# EUROPEAN PATENT APPLICATION

(11) **EP 4 589 649 A1**
(43) Date of publication of application: **23.07.2025**
(21) Application number: 24220228.1
(22) Date of filing: 16.12.2024
(51) Int. Cl.: H01L 21/78, H01L 23/36

(54) **CHIP STRUCTURE AND METHOD OF MANUFACTURING THE SAME**

(30) Priority: 22.01.2024 TW 113102485
(71) Applicant: Chipbond Technology Corporation, 300 Hsinchu (TW)
(72) Inventor: Shih, Cheng-Hung, Lugang Township, Changhua County (TW); Hsieh, Yung-Wei, Hsinchu (TW); Cheng, Pai-Sheng, Hsinchu (TW)
(74) Representative: Beck & Rössig European Patent Attorneys

(57) **Abstract**

In a method of manufacturing chip structures, an active surface of a chip is adhered to a carrier and a heat-dissipation layer is formed on a back surface of the chip. Because of a half groove surrounding the active surface of the chip, metal residues will not accumulate in a gap between the active surface and the carrier to contaminate the chip during formation of the heat-dissipation layer.

## Description

### FIELD OF THE INVENTION

This invention relates to a chip structure, and more particularly to a chip structure with a heat-dissipation layer formed on a back surface of a chip.

### BACKGROUND OF THE INVENTION

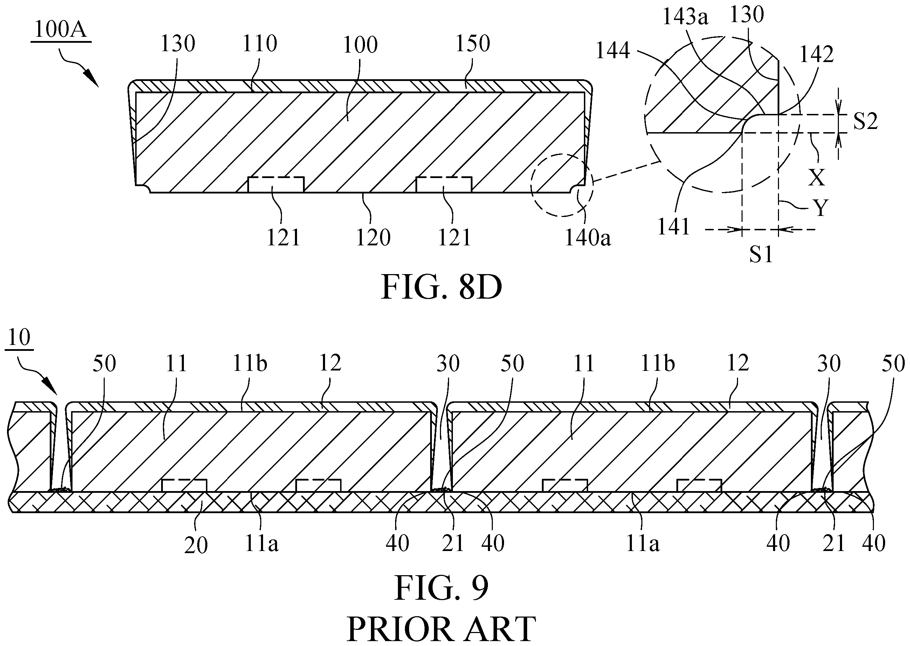

With reference to Fig. 9, a conventional wafer 10 is adhered to a surface 21 of a tape 20 via an active surface 11a of each of chips 11. There is a groove 30 between the adjacent chips 11, and the surface 21 of the tape 20 is visible from the groove 30. A heat-dissipation layer 12 is formed on a back surface 11b of each of the chips 11 through sputtering process.

During sputtering formation of the heat-dissipation layer 12 on the back surface 11b, a gap 40 may be observed between the active surface 11a and the tape 20 due to physical properties of the chip 11 and the tape 20 or process environment variation (e.g. temperature). Spattering target atoms may accumulate on the tape 20 and in the gap 40 to become metal residues 50, and the metal residues 50 may be adhered to the active surface 11a to lower quality and yield of the chips 11.

### SUMMARY OF THE INVENTION

One object of the present invention is to provide a chip structure and its manufacturing method. During formation of a heat-dissipation layer on a chip backside, it is available to prevent metal residues from accumulating in a gap between an active surface of the chip and a carrier to reduce quality and yield of the chip.

A chip structure of the present invention and according to claim 1 includes a chip and a heat-dissipation layer. The chip has a back surface, an active surface, a lateral surface and a half grove, and the heat-dissipation layer covers the back surface. The half groove surrounds the active surface, is located between the active surface and the lateral surface and has a first edge adjacent to the active surface and a second edge adjacent to the lateral surface.

In a method of manufacturing a chip structure of the present invention and according to claim 7, chips are adhered to a second carrier, each of the chips has a back surface, an active surface, a lateral surface and a half groove. The half groove surrounds the active surface, is located between the active surface and the lateral surface and has a first edge adjacent to the active surface and a second edge adjacent to the lateral surface. Each of the chips is adhered to the second carrier via its active surface such that the half groove becomes a sheltering space between each of the chips and the second carrier. Next, a heat-dissipation layer is formed on the back surface of each of the chips to obtain chip structures.

Advantageous embodiments are set out in further claims.

The half groove surrounding the active surface can become the sheltering space located between the chip and the second carrier, and it can prevent spattering target atoms from accumulating in the gap between the active surface of the chip and the second carrier to become metal residues. Consequently, the chip is protected from contamination or damage caused by the metal residues.

A "half groove" may be derived from a groove by cutting through its bottom. Whereas a groove may be formed by a bottom between two opposing lateral walls, a half groove may have a bottom and just one lateral wall.

### BRIEF DESCRIPTION OF DRAWING

Fig. 1 is a top view diagram illustrating a wafer in accordance with one embodiment of the present invention.
Fig. 2 is a cross-section view diagram illustrating a wafer in accordance with one embodiment of the present invention.
Fig. 3 is a top view diagram illustrating a part of a wafer in accordance with one embodiment of the present invention.
Figs. 4A to 8D are cross-section view diagrams illustrating a method of manufacturing chip structures in accordance with one embodiment of the present invention.
Fig. 9 is a cross-section view diagram illustrating a conventional chip structure.

### DETAILED DESCRIPTION OF THE INVENTION

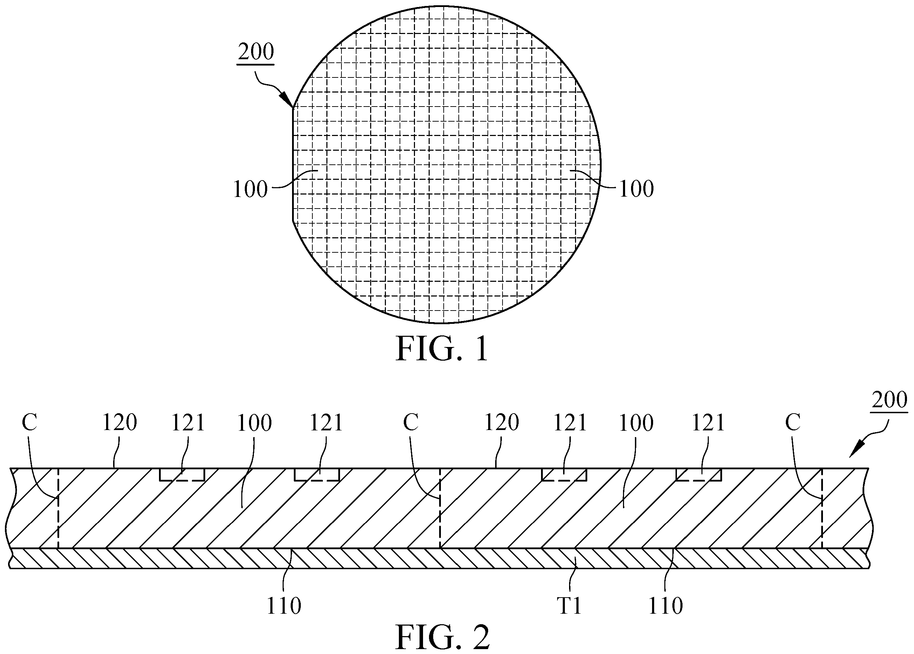

With reference to Figs. 1 and 2, in a method of manufacturing chip structures of the present invention, a wafer 200 is provided firstly. The wafer 200 involves a plurality of chips 100 which are connected to one another, each of the chips 100 has a back surface 110 and an active surface 120. In this embodiment, a plurality of pads 121 are arranged on the active surface 120 and they are electrically connected to a redistribution layer (RDL, not shown). The wafer 200 is adhered to a first carrier T1 via the back surface 110 of each of the chips 100, and the active surface 120 of each of the chips 100 is visible.

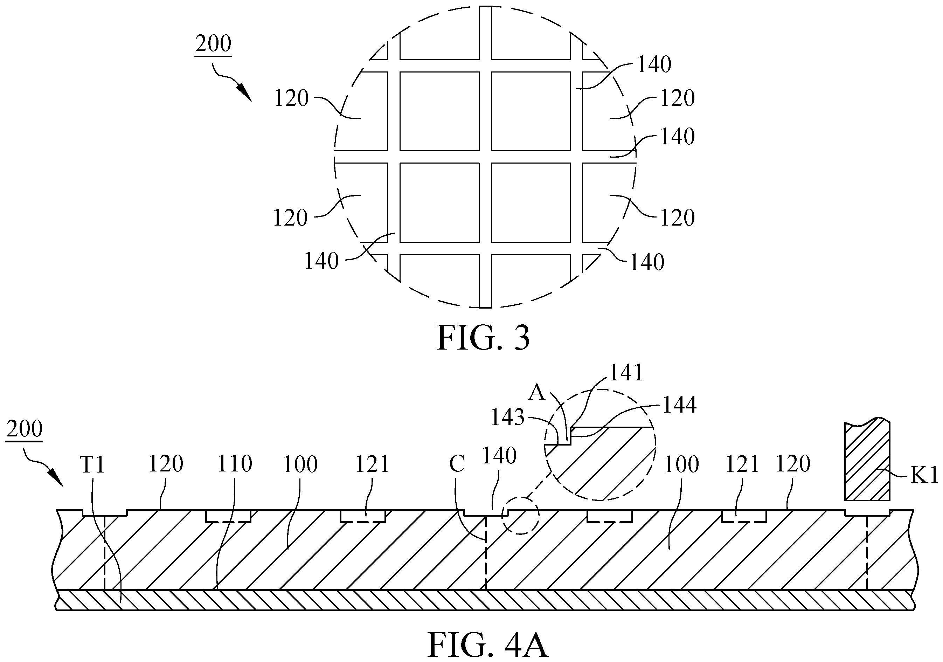

With reference to Figs. 3 and 4A, a groove 140 is formed on the active surface 120 and it surrounds the active surface 120. Preferably, the wafer 200 is cut by a first dicer K1 along a cutting lane C to form the groove 140 surrounding the active surface 120 in an endless loop. As shown in Fig. 3, a plurality of embossed active surfaces 120 may be surrounded respectively by grooves 140. The groove 140 has a bottom surface 143 and two first edges 141 which are opposite to each other and adjacent to the active surface 120. The cross-sectional shape of the groove 140 is decided by the profile of the first dicer K1, and it may be different as shown in Figs. 4A to 4D when using different dicers.

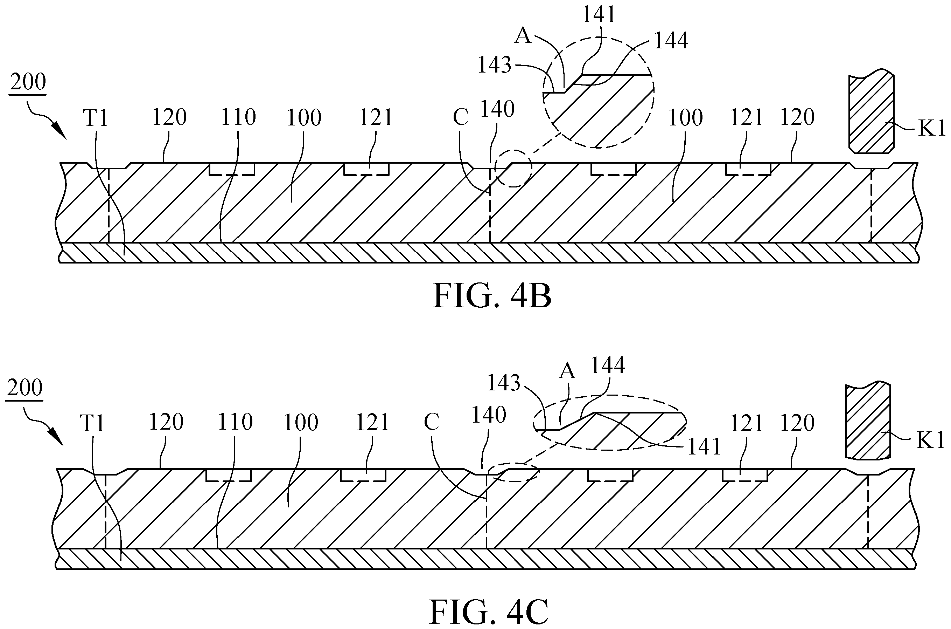

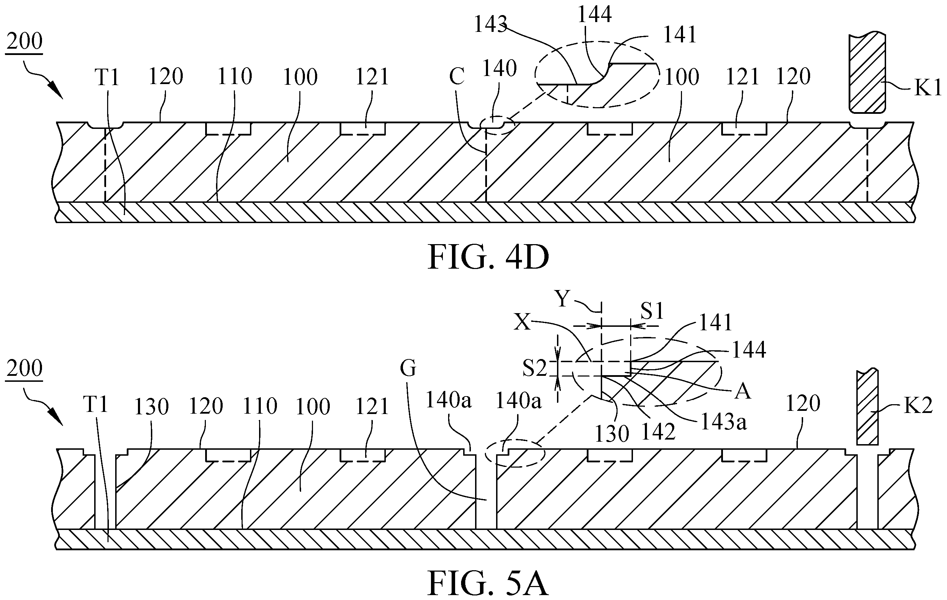

With reference to Figs. 4A to 4C, the groove 140 has two groove lateral surfaces 144 which are opposite to each other, and each of the first edges 141 is located on one of the groove lateral surfaces 144. Each of the groove lateral surfaces 144 is connected to the bottom surface 143, and an included angle A larger than or equal to 90 degrees exits between the groove lateral surface 144 and the bottom surface 143. The groove lateral surface 144 as shown in Fig. 4A is perpendicular to the bottom surface 143 so the included angle A is 90 degrees, and the included angles A as shown in Figs. 4B and 4C are larger than 90 degrees. Different to the embodiments as shown in Figs. 4A to 4C, the groove lateral surface 144 as shown in Fig. 4D is an arc surface.

With reference to Figs. 5A to 5D, after the formation of the groove 140, the wafer 200 is cut again by a second dicer K2 along the bottom surface 143 of the groove 140 and the cutting lane C to separate the chips 100, each of the separated chips 100 has a lateral surface 130, and the groove 140 is cut into two half grooves 140a. The half groove 140a surrounds the active surface 120 and is located between the active surface 120 and the lateral surface 130 of the chip 100. The half groove 140a has the first edge 141 and a second edge 142, the first edge 141 is adjacent to the active surface 120 and the second edge 142 is adjacent to the lateral surface 130. The half groove 140a has one of said lateral surfaces 144 and a part of the bottom surface 143 of groove 140.

With reference to Figs. 5A to 5D, a first imaginary line Y extending along the lateral surface 130 passes through the second edge 142, and a second imaginary line X extending along the active surface 120 passes through the first edge 141. A first distance S1 from the first edge 141 to the first imaginary line Y is greater than or equal to 3 µm and less than or equal to 10 µm (3 µm ≤ S1 ≤ 10 µm). A second distance S2 from the second edge 142 to the second imaginary line X is greater than or equal to 5 µm and less than or equal to 120 µm (5 µm ≤ S2 ≤ 120 µm). The quotient of S2 divided by S1 is greater than or equal to 0.5 and less than or equal to 40 (0.5 ≤ S2/S1 ≤ 40).

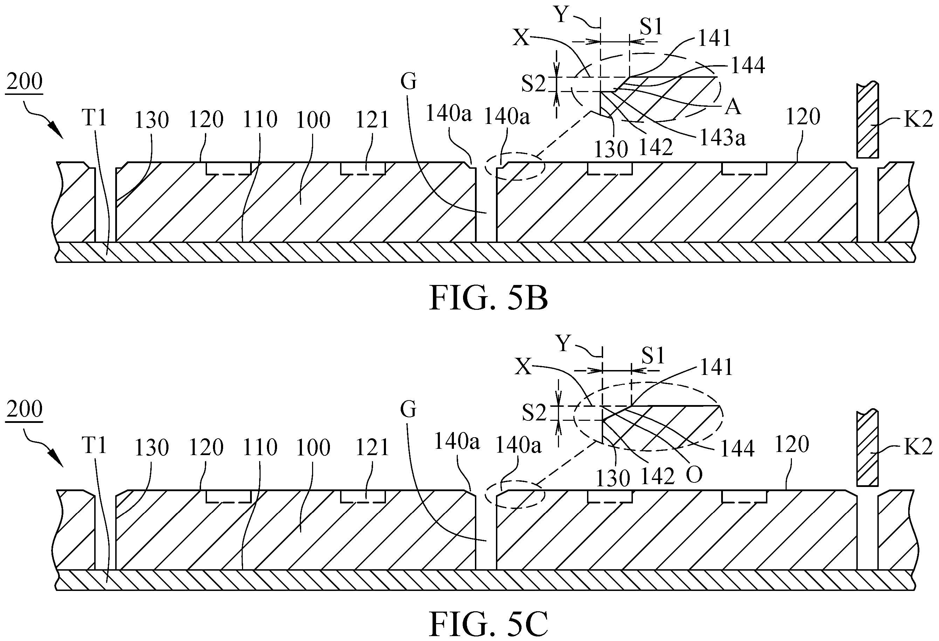

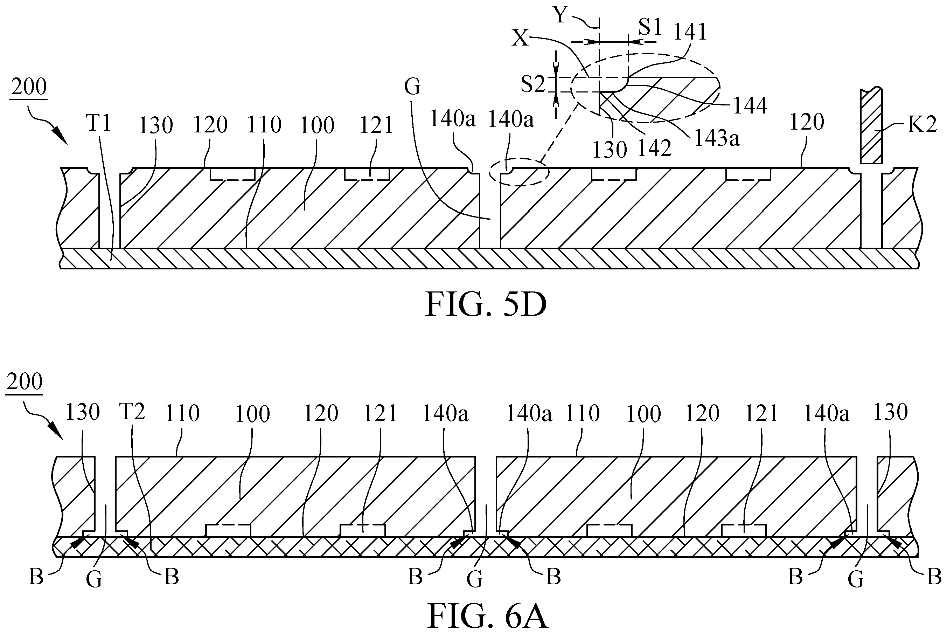

With reference to Figs. 5A and 5B, during separation of the chips 100, the second dicer K2 is provided to cut the wafer 200 along the bottom surface 143 of the groove 140, thus the bottom surface 143 is cut into two groove bottom surfaces 143a. The groove bottom surface 143a is connected to the groove lateral surface 144, and the included angle A exists between the groove bottom surface 143a and the groove lateral surface 144. In these embodiments as shown in Figs. 5A and 5B, the second edge 142 is located on the groove bottom surface 143a, the groove lateral surface 144 faces toward the first imaginary line Y, and the groove bottom surface 143a faces toward the second imaginary line X. In another embodiment as shown in Fig. 5D, the groove lateral surface 144 is an arc surface connected to the groove bottom surface 143a.

In another embodiment as shown in Fig. 5C, the bottom surface 143 of the groove 140 is cut and removed by the second dicer K2. After separating the chips 100, the groove lateral surface 144 is retained on the half groove 140a, the first edge 141 and the second edge 142 is located on the groove lateral surface 144, and the groove lateral surface 144 faces toward an intersection point O of the first imaginary line Y and the second imaginary line X.

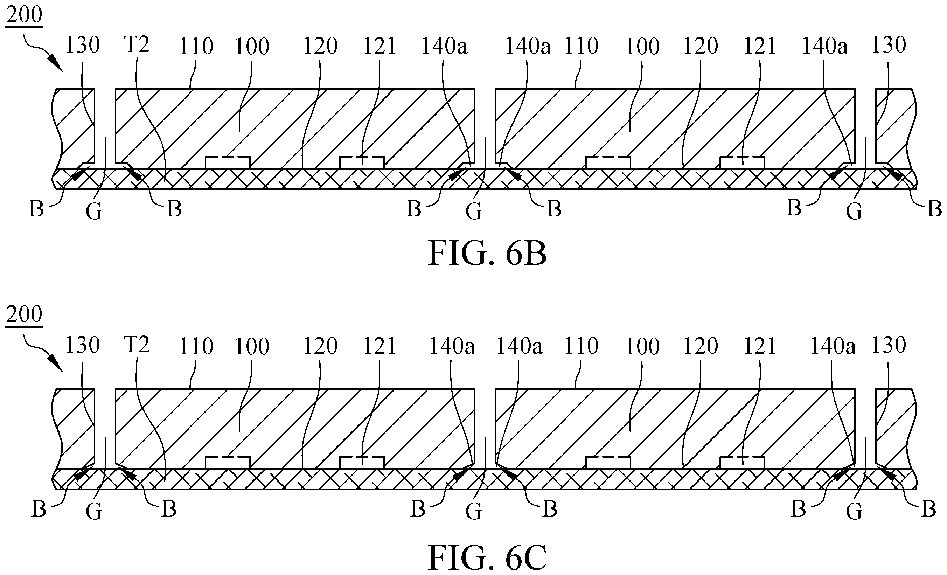

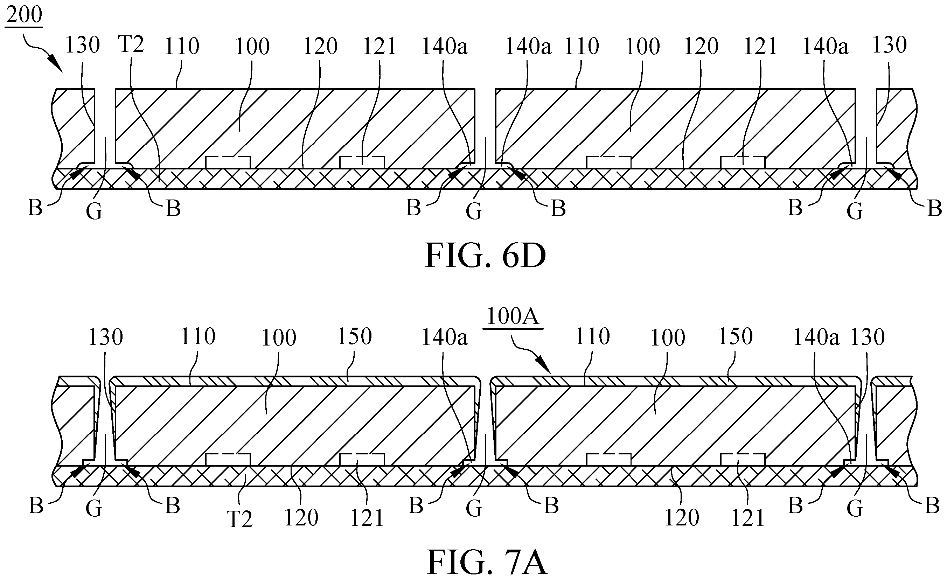

With reference to Figs. 6A to 6D, the separated chips 100 are adhered to a second carrier T2 via the active surface 120 such that the half groove 140a on each of the chips 100 becomes a sheltering space B located between the chip 100 and the second carrier T2. A gap G between the lateral surfaces 130 of the adjacent chips 100 is greater than or equal to 20 µm and less than or equal to 1 mm (20 µm ≤ G ≤ 1 mm). Then, the first carrier T1 is removed to allow the back surface 110 of each of the chips 100 to be visible. The first carrier T1 and the second carrier T2 can be adhesive tapes, glass substrates or silicon substrates.

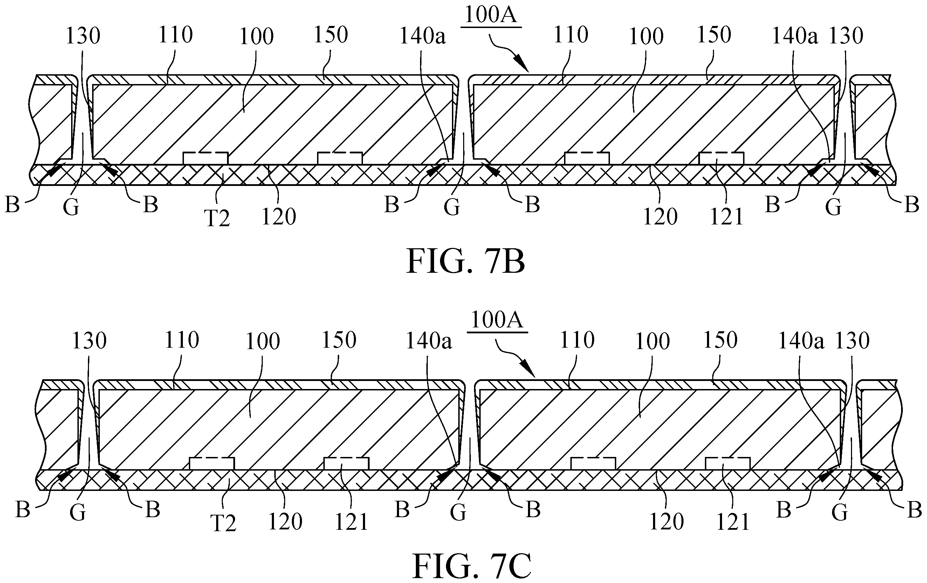

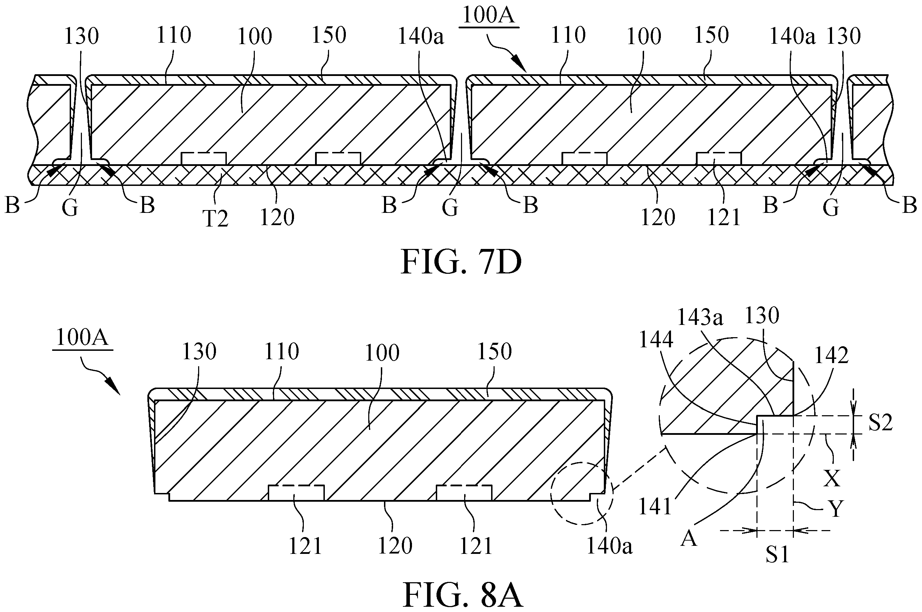

With reference to Figs. 7A to 7D, a heat-dissipation layer 150 is formed on the back surface 110 of each of the chips 100 to obtain a plurality of chip structures 100A. Preferably, the heat-dissipation layer 150 is a heat-dissipation cover covering the back surface 110 and the lateral surface 130 of each of the chips 100. The heat-dissipation layer 150 may be formed through sputtering process, and the sheltering space B located between each of the chips 100 and the second carrier T2 can prevent spattering target atoms from accumulating in a gap (not shown) between the second carrier T2 and the active surface 120 of each of the chips 100, thus metal residues which may contaminate or damage the chips 100 will not generate.

With reference to Figs. 8A to 8D, the chip structures 100A can be separated from the second carrier T2 by a robot (not shown) in pick-and-place process.

Shapes of the half grooves 140a of the chip structures 100A as shown in Figs. 8A to 8D are different. Each of the chip structures 100A includes the chip 100 and the heat-dissipation layer 150. The half groove 140a surrounds the active surface 120 and is located between the active surface 120 and the lateral surface 130. The half groove 140a has the first edge 141 adjacent to the active surface 120 and the second edge 142 adjacent to the lateral surface 130. The heat-dissipation layer 150 covers the back surface 110, and preferably, it also covers the lateral surface 130.

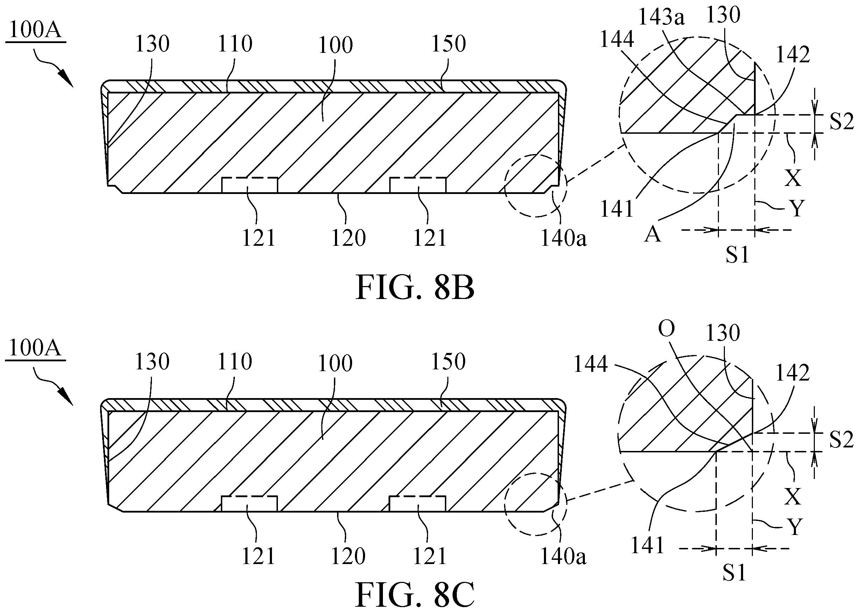

With reference to Figs. 8A and 8B, the half groove 140a has the groove lateral surface 144 and the groove bottom surface 143a. The first edge 141 is located on the groove lateral surface 144, and the second edge 142 is located on the groove bottom surface 143a. The groove lateral surface 144 faces toward the first imaginary line Y, the groove bottom surface 143a faces toward the second imaginary line X, the groove lateral surface 144 is connected to the groove bottom surface 143a and the included angle A greater than or equal to 90 degrees exists between the groove lateral surface 144 and the groove bottom surface 143a. In the embodiment as shown in Fig. 8A, the groove lateral surface 144 is perpendicular to the groove bottom surface 143a, and the included angle A is 90 degrees. The included angle A is greater than 90 degrees in the embodiment as shown in Fig. 8B, and the groove lateral surface 144 is an arc surface and connected to the groove bottom surface 143a in the embodiment as shown in Fig. 8D.

The half groove 140a of the embodiment as shown in Fig. 8C only has the groove lateral surface 144, the first edge 141 and the second edge 142 are located on the groove lateral surface 144 which faces toward the intersection point O of the first imaginary line Y and the second imaginary line X.

The groove 140 is formed on the active surface 120 to surround the active surface 120 before singulation of the chips 100, and the groove 140 becomes the half groove 140a surrounding the active surface 120 after singulation of the chips 100. The active surfaces 120 of the separated chips 100 are adhered to the second carrier T2 to allow the half groove 140a on each of the chips 100 to become the sheltering space B. During sputtering formation of the heat-dissipation layer 150, the sheltering space B can avoid spattering target atoms from accumulating in the gap (not shown) between the second carrier T2 and the active surface 120. Consequently, the chips 100 can be protected from contamination or damage caused by metal residues.

While this invention has been particularly illustrated and described in detail with respect to the preferred embodiments thereof, it will be clearly understood by those skilled in the art that is not limited to the specific features shown and described and various modified and changed in form and details may be made without departing from the scope of the claims.

## Claims

1. A chip structure (100A) comprising:
a chip (100) having a back surface (110), an active surface (120), a lateral surface (130) and a half groove (140a), wherein the half groove (140a) surrounds the active surface (120), is located between the active surface (120) and the lateral surface (130), and has a first edge (141) adjacent to the active surface (120) and a second edge (142) adjacent to the lateral surface (130); and
a heat-dissipation layer (150) covering the back surface (110).

2. The chip structure (100A) in accordance with claim 1, wherein the second edge (142) is passed by a first imaginary line (Y) extending along the lateral surface (130), the first edge (141) is passed by a second imaginary line (X) extending along the active surface(120), a first distance (S1) from the first edge (141) to the first imaginary line (Y) is greater than or equal to 3 µm and less than or equal to 10 µm, a second distance (S2) from the second edge (142) to the second imaginary line (X) is greater than or equal to 5 µm and less than or equal to 120 µm, and a quotient of the second distance (S2) divided by the first distance (S1) is greater than or equal to 0.5 and less than or equal to 40.

3. The chip structure (100A) in accordance with claim 1 or 2, wherein the second edge (142) is passed by a first imaginary line (Y) extending along the lateral surface(130), the first edge (141) is passed by a second imaginary line (X) extending along the active surface (120), the half groove (140a) further has a groove lateral surface (144) and a groove bottom surface (143a) which are connected to each other, the first edge (141) is located on the groove lateral surface (144), the second edge (142) is located on the groove bottom surface (143a), the groove lateral surface (144) faces toward the first imaginary line (Y) and the groove bottom surface (143a) faces toward the second imaginary line (X), and there is an included angle (A) greater than or equal to 90 degrees between the groove lateral surface (144) and the groove bottom surface (143a).

4. The chip structure (100A) in accordance with claim 1 or 2, wherein the second edge (142) is passed by a first imaginary line (Y) extending along the lateral surface (130), the first edge (141) is passed by a second imaginary line (X) extending along the active surface (120), the half groove (140a) further has a groove lateral surface (144), the first edge (141) and the second edge (142) are located on the groove lateral surface (144), and the groove lateral surface (144) faces toward an intersection point (O) of the first imaginary line (Y) and the second imaginary line (X).

5. The chip structure (100A) in accordance with claim 1 or 2, wherein the half groove (140a) further has a groove lateral surface (144) and a groove bottom surface (143a) which are connected to each other, the groove lateral surface (144) is an arc surface and is located between the groove bottom surface (143a) and the active surface (120), and the second edge (142) is located on the groove bottom surface (143a).

6. The chip structure (100A) in accordance with one of claims 1 to 5, wherein the groove lateral surface (144) is connected to the active surface (120), and the first edge (141) is located on the groove lateral surface (144).

7. A method of manufacturing chip structures comprising:
adhering a plurality of chips (100) on a second carrier (T2), each of the plurality of chips (100) has a back surface (110), an active surface (120), a lateral surface (130) and a half groove (140a) which surrounds the active surface (120) and is located between the active surface (120) and the lateral surface(130), the half groove (140a) has a first edge (141) adjacent to the active surface (120) and a second edge (142) adjacent to the lateral surface (130), wherein each of the plurality of chips (100) is adhered to the second carrier (T2) via the active surface (120) such that the half groove (140a) becomes a sheltering space (B) between the second carrier (T2) and each of the plurality of chips (100); and
forming a heat-dissipation layer (150) on the back surface (110) of each of the plurality of chips (100) to obtain a plurality of chip structures (100A).

8. The method in accordance with claim 7, wherein before adhering the plurality of chips (100) to the second carrier (T2), a wafer (200) including the plurality of chips (100) connected to one another is adhered to a first carrier (T1), the back surface (110) of each of the plurality chips (100) is adhered on the first carrier (T1) and the active surface (120) of each of the plurality of chips (100) is visible, a groove (140) is formed on the active surface (120), surrounds the active surface (120) and has a bottom surface (143) and two opposite first edges(141), the wafer (200) is diced along the bottom surface (143) of the groove (140) such that the plurality of chips (100) are separated and the groove (140) becomes two half grooves (140a), each of the plurality of chips (100) has the lateral surface (130), the first edge (141), the second edge (142) and the half groove (140a), and the first carrier (T1) is removed to allow the back surface (110) of each of the plurality of chips (100) to be visible after adhering the active surface (120) of each of the plurality of chips (100) to the second carrier (T2).

9. The method in accordance with claim 7 or 8, wherein a gap (G) between the lateral surfaces (130) of the adjacent chips (100) which are adhered to the second carrier (T2) is greater than or equal to 20 µm and less than or equal to 1 mm.

10. The method in accordance with one of claims 7 to 9, wherein the second edge (142) is passed by a first imaginary line (Y) extending along the lateral surface (130), the first edge (141) is passed by a second imaginary line (X) extending along the active surface (120), a first distance (S1) from the first edge (141) to the first imaginary line (Y) is greater than or equal to 3 µm and less than or equal to 10 µm, a second distance (S2) from the second edge (142) to the second imaginary line (X) is greater than or equal to 5 µm and less than or equal to 120 µm, and a quotient of the second distance (S2) divided by the first distance (S1) is greater than or equal to 0.5 and less than or equal to 40.

11. The method in accordance with one of claims 8 to 10, wherein the groove (140) has two opposite groove lateral surfaces (144), each of the first edges (141) is located on one of the groove lateral surfaces (144), the groove lateral surfaces (144) are connected to the bottom surface (143), there is an included angle (A) greater than or equal to 90 degrees between each of the groove lateral surfaces (144) and the bottom surface (143), after separating the plurality of chips (100), the bottom surface (143) becomes two groove bottom surfaces (143a), each of the groove lateral surfaces (144) is connected to one of the groove bottom surfaces (143a), the second edge (142) is located on each of the groove bottom surfaces (143a), and there is the included angle (A) between each of the groove lateral surfaces (144) and each of the groove bottom surfaces (143a).

12. The method in accordance with one of claims 8 to 10, wherein the groove (140) has two opposite groove lateral surfaces (144), each of the first edges (141) is located on one of the groove lateral surfaces (144), the groove lateral surfaces (144) are connected to the bottom surface (143), there is an included angle (A) greater than 90 degrees between each of the groove lateral surfaces (144) and the bottom surface (143), the bottom surface (143) is removed during separating the plurality of chips (100), each of the groove lateral surfaces (144) is retained on one of the half grooves (140a) and the second edge (142) is located on each of the groove lateral surfaces (144) after separating the plurality of chips (100).

13. The method in accordance with one of claims 8 to 10, wherein the groove (140) has two opposite groove lateral surfaces (144) which each is an arc surface connected to the bottom surface (143), after separating the plurality of chips (100), the bottom surface (143) becomes two groove bottom surfaces (143a), the second edge (142) is located on each of the groove bottom surfaces (143a), each of the groove lateral surfaces (144) is connected to one of the groove bottom surfaces (143a) and located between one of the groove bottom surfaces (143a) and the active surface (120).

14. The method in accordance with claim 13, wherein the first edge (141) is located on each of the groove lateral surfaces (144) which are connected to the active surface (120).
